# EUROPÄISCHE PATENTSCHRIFT

(11) **EP 2 559 327 B1**
(45) Veröffentlichungstag und Bekanntmachung des Hinweises auf die Patenterteilung: **16.05.2018**
(21) Anmeldenummer: 11730863.5
(22) Anmeldetag: 11.04.2011
(51) Int. Cl.: H05K 1/18, H05K 3/46, H05K 1/02

(54) **VERFAHREN ZUR INTEGRATION EINES ELEKTRONISCHEN BAUTEILS IN EINE LEITERPLATTE**
METHOD FOR INTEGRATING AN ELECTRONIC COMPONENT INTO A PRINTED CIRCUIT BOARD
PROCÉDÉ D'INTÉGRATION D'UN COMPOSANT ÉLECTRONIQUE DANS UNE CARTE DE CIRCUITS IMPRIMÉS

(30) Priorität: 13.04.2010 AT 23610 U
(43) Veröffentlichungstag der Anmeldung: 20.02.2013
(73) Patentinhaber: AT & S Austria Technologie & Systemtechnik Aktiengesellschaft, 8700 Leoben-Hinterberg (AT)
(72) Erfinder: STAHR, Johannes, A-8605 St. Lorenzen (AT); LEITGEB, Markus, A-8793 Trofaiach (AT)
(74) Vertreter: Miksovsky, Alexander
(86) Internationale Anmeldenummer: PCT/AT2011/000172
(87) Internationale Veröffentlichungsnummer: WO 2011/127503

(56) Entgegenhaltungen:
- WO-A1-2008/098269
- WO-A1-2010/095210
- DE-A1-102007 036 045
- US-A1- 2007 176 613
- US-A1- 2009 042 336
- US-A1- 2009 097 214

## Beschreibung

Die vorliegende Erfindung bezieht sich auf ein Verfahren zur Integration eines elektronischen Bauteils in eine Leiterplatte gemäß Anspruch 1, umfassend die folgenden Schritte:
- Bereitstellen von zwei fertig gestellten, und insbesondere aus einer Mehrzahl von miteinander verbundenen Lagen bzw. Schichten bestehenden Leiterplattenelementen, wobei wenigstens ein Leiterplattenelement eine Ausnehmung bzw. Vertiefung aufweist,
- Anordnen des zu integrierenden Bauteils auf einem der Leiterplattenelemente oder in der Ausnehmung des wenigstens einen Leiterplattenelements, und
- Verbinden der Leiterplattenelemente unter Aufnahme des Bauteils in der Ausnehmung, wobei in der Leiterplatte eine Auswerteelektronik für den Bauteil integriert wird und wobei im Bereich von Kontaktierungen des zu integrierenden Bauteils eine Schicht aus einem hermetisch dichten, nicht leitenden Material in einem Leiterplattenelement eingebettet wird und eine Kontaktierung des Bauteils über durch die hermetisch dichtende Schicht ausgebildete Sacklöcher vorgenommen wird, welche mit einem leitenden Material, einer Plattierung oder dgl. gefüllt werden.

Im Zusammenhang mit der Herstellung von Leiterplatten mit wenigstens einem darin integrierten elektronischen Bauteil ist es bekannt, in einer insbesondere mehrlagigen Leiterplatte einen derartigen elektronischen Bauteil insbesondere unter Anpassung von den Bauteil umgebenden Schichten bzw. Lagen einer derartigen mehrlagigen Leiterplatte aufzunehmen, woran anschließend an sich bekannte Verfahren zur Verbindung derartiger, insbesondere unterschiedlicher Lagen einer mehrlagigen Leiterplatte zum Einsatz gelangen. Zur Verbindung derartiger Schichten bzw. Lagen einer mehrlagigen Leiterplatte werden dabei derartige Verbundstrukturen üblicherweise erhöhtem Druck und/oder erhöhter Temperatur ausgesetzt, wodurch zumindest aus Kunststoffen, wie beispielsweise Harzen oder dgl. bestehende Lagen wenigstens teilweise erweicht bzw. geschmolzen werden, um die gewünschte Verbindung der Schichten bzw. Lagen als auch ein Einbetten wenigstens eines elektronischen Bauteils in der Leiterplatte sicherzustellen. Ein derartiges Verfahren zur Einbettung eines elektronischen Bauteils in einer Leiterplatte, bei welchem auch der elektronische Bauteil derartigen Verfahrensschritten zur Herstellung der gewünschten Verbindungen unterworfen wird, ergibt eine üblicherweise für eine gewisse Bauart von elektronischen Bauteilen gewünschte vollständige Ummantelung bzw. Einbettung eines derartigen Bauteils in die mehrlagige Leiterplatte durch ein Erweichen bzw. Schmelzen von insbesondere umgebenden Kunststoffschichten. Derartige bekannte Verfahren, bei welchen während des Aufbaus der mehrlagigen Struktur der Leiterplatte unmittelbar ein elektronischer Bauteil integriert wird und nachfolgend entsprechend Be- bzw. Verarbeitungsschritte zur Herstellung der Verbindung zwischen den einzelnen Schichten bzw. Lagen einer Leiterplatte unterworfen wird, sind jedoch nicht anwendbar, wenn eine derartige Verbindung des Bauteils mit umgebenden, insbesondere isolierenden Materialien nicht gewünscht bzw. nicht zulässig ist.

Eine Ausführungsform, bei welcher eine derartige unmittelbare Einbettung eines elektronischen Bauteils nicht erwünscht bzw. zielführend ist, ist beispielsweise aus der GB-A 2 451 921 bekannt geworden, wobei auf einer mehrlagigen Leiterplatte ein elektronischer Bauteil, beispielsweise ein kapazitives Mikrofon angeordnet ist. Zur Abschirmung wird nach der Anordnung des Bauteils auf der mehrlagigen Leiterplatte in getrennten und aufwendigen zusätzlichen Arbeitsschritten eine metallische Abschirmung nach Art eines Deckels auf der Leiterplatte festgelegt, wobei unmittelbar einsichtig ist, dass ein erheblicher zusätzlicher Aufwand für eine derartige getrennte Herstellung und Festlegung einer beispielsweise von einem Metallkäfig gebildeten Abschirmung erforderlich ist, welcher darüber hinaus keineswegs eine geschützte und sichere Aufnahme des Bauteils ermöglicht.

Aus der US 2009/0321921 A1 sind eine eingebettete Leiterplatte und ein Verfahren zur Herstellung derselben bekannt geworden, wobei auf eine vereinfachte Kontaktierung unterschiedlicher Elemente der Leiterplatte abgezielt wird.

Ein Verfahren ähnlich der eingangs genannten Art ist beispielsweise der DE 10 2007 036045 A1 zu entnehmen, wobei auf eine Verkapselung von Bauelementen zur Erzielung einer entsprechenden Stabilität auch bei höheren Temperaturen abgezielt wird. Ähnliche Ausbildungen sind beispielsweise auch der US 2007/0176613 A1, der US 2009/0097214 A1 oder der US 2009/0042336 A1 zu entnehmen.

Die vorliegende Erfindung zielt daher darauf ab, ein Verfahren zur Integration eines elektronischen Bauteils in eine Leiterplatte zur Verfügung zu stellen, wobei die Nachteile gemäß dem Stand der Technik vermieden werden und eine Verbindung bzw. im wesentlichen vollständige Ummantelung eines derartigen integrierten Bauteils während nachfolgender Be- bzw. Verarbeitungsschritte einer derartigen Leiterplatte bei geschützter Aufnahme des Bauteils zuverlässig vermieden wird. Weiters wird auf einen Schutz sowohl des zu integrierenden Bauteils als auch eines mit dem Bauteil zu koppelnden Elements abgezielt.

Zur Lösung dieser Aufgaben ist ein Verfahren der eingangs genannten Art im wesentlichen dadurch gekennzeichnet, dass der elektronische Bauteil in in der Ausnehmung aufgenommenem Zustand gegenüber der Außenumgebung der zwei Leiterplattenelemente und/oder benachbarten Bereichen der Leiterplattenelemente abgeschirmt wird und dass die Ausnehmung in dem wenigstens einen Leiterplattenelement durch ein Freistellen eines Teilbereichs des Leiterplattenelements nach der Verbindung von miteinander zu verbindenden Lagen des Leiterplattenelements unter Verwendung eines ein Anhaften des Teilbereichs verhindernden Materials hergestellt wird.

Da zwei fertig gestellte Leiterplattenelemente, welche insbesondere aus einer Mehrzahl von miteinander verbundenen Lagen bzw. Schichten bestehen, bereitgestellt werden, wobei wenigstens ein Leiterplattenelement eine Ausnehmung bzw. Vertiefung zur nachfolgenden Aufnahme des in die Leiterplatte zu integrierenden Bauteils aufweist, wird sichergestellt, dass während nachfolgender Be- bzw. Verarbeitungsschritten der Leiterplatte, beispielsweise auch während der Verbindung der beiden fertig gestellten Leiterplattenelemente eine neuerliche bzw. zusätzliche Verformung von einzelnen Schichten bzw. Lagen der Leiterplattenelemente zuverlässig vermieden wird, da insbesondere keine Änderungen der Abmessungen der Ausnehmung bzw. Vertiefung auftreten bzw. zu erwarten sind, welche bei zusammengebautem Zustand der miteinander zu verbindenden Leiterplattenelemente eine Aufnahme des elektronischen Bauteils sicherstellt. Dadurch, dass in der Leiterplatte eine Auswerteelektronik für den Bauteil integriert wird, kann beispielsweise die Auswerteelektronik unmittelbar gemeinsam mit dem Bauteil durch Aufnahme innerhalb der Abschirmung ebenfalls gegenüber Umwelteinflüssen entsprechend geschützt werden. Es ist somit wesentlich für das erfindungsgemäße Verfahren, die zur Einbettung bzw. Integration des elektronischen Bauteils sowie der damit zu koppelnden Auswerteelektronik zur Verfügung zu stellenden Leiterplattenelemente als fertig gestellte Leiterplattenelemente bzw. als Halbfertig- oder Fertigprodukt bereitzustellen, bei welchen im Gegensatz zu bekannten Verfahrensführungen während nachfolgender Be- bzw. Verarbeitungsschritte eine Verformung oder dgl. von einzelnen Lagen der Leiterplatten nicht befürchtet werden muss, wodurch eine Verformung des zur Aufnahme des elektronischen Bauteils vorgesehenen Freiraums im Bereich der Ausnehmung bzw. Vertiefung vermieden werden kann. In Abhängigkeit von den Eigenschaften des zu integrierenden bzw. aufzunehmenden elektronischen Bauteils wird wenigstens eine Ausnehmung in wenigstens einem der fertig gestellten Leiterplattenelemente zur Verfügung gestellt, um in weiterer Folge bei einem Anordnen und Aufnehmen des elektronischen Bauteils in der wenigstens einen Ausnehmung einen für den aufzunehmenden elektronischen Bauteil ausreichenden und angepassten Aufnahmeraum zur geschützten Aufnahme desselben darin zur Verfügung zu stellen. Anstelle einer Ausbildung einer Ausnehmung in lediglich einem der Leiterplattenelemente, um den gesamten elektronischen Bauteil in dem Leiterplattenelement in zusammengebautem Zustand aufzunehmen, können selbstverständlich aufeinander abgestimmte Ausnehmungen bzw. Vertiefungen in beiden Leiterplattenelementen vorgesehen sein, welche in zusammengebautem und verbundenem Zustand den für die Aufnahme des elektronischen Bauteils erforderlichen Freiraum zur Verfügung stellen. In einigen Fällen ist zur Vermeidung von Umgebungseinflüssen auf von dem Sensor festzustellenden Messgrößen oder Werte eine entsprechende Abschirmung des Sensors erforderlich, wofür erfindungsgemäß vorgesehen ist, dass der elektronische Bauteil in in der Ausnehmung aufgenommenem Zustand gegenüber der Außenumgebung der zwei Leiterplattenelemente und/oder benachbarten Bereichen der Leiterplattenelemente abgeschirmt wird. Neben einer Abschirmung gegenüber elektromagnetischer Strahlung durch Ausbildung einer einen zu integrierenden elektronischen Bauteil im wesentlichen über den gesamten Umfang umgebenden elektromagnetischen Abschirmung nach Art eines Faraday'schen Käfigs ist in einigen Anwendungsformen eine im wesentlichen hermetisch dichte Abschirmung bzw. Kapselung eines derartigen Sensors gegenüber äußeren Umgebungseinflüssen erforderlich, wobei insbesondere Kunststoffschichten, welche beispielsweise als isolierende Materialien in mehrlagigen Leiterplatten zum Einsatz gelangen, hiefür nicht die erforderliche Undurchlässigkeit aufweisen. Darüber hinaus ist unmittelbar einsichtig, dass im Bereich von Kontaktierungen des elektronischen Bauteils zur Vermeidung von Kurzschlüssen nicht im wesentlichen vollflächige leitende Abschirmungen, welche aufgrund ihrer Materialeigenschaften gegebenenfalls auch eine entsprechende Abschirmung gegenüber äußeren Umgebungseinflüssen zur Verfügung stellen würden, eingesetzt werden können. In diesem Zusammenhang wird zur Erzielung der Abschirmung gegenüber derartigen Umwelteinflüssen und zur gleichzeitigen Bereitstellung einer sicheren Kontaktierung des Bauteils vorgesehen, dass im Bereich von Kontaktierungen des zu integrierenden Bauteils eine Schicht aus einem hermetisch dichten, nicht leitenden Material in einem Leiterplattenelement eingebettet wird und eine Kontaktierung des Bauteils über durch die hermetisch dichtende Schicht ausgebildete Sacklöcher vorgenommen wird, welche mit einem leitenden Material, einer Plattierung oder dgl. gefüllt werden. Derartige hermetisch dichtende Schichten bzw. Lagen lassen sich in einfacher und zuverlässiger Weise in eine mehrlagige Leiterplatte entsprechend der beabsichtigten Positionierung des zu integrierenden elektronischen Bauteils aufnehmen und stellen insbesondere im Bereich von Kontaktierungen derartiger Bauteile eine entsprechende hermetische Abdichtung gegenüber Umwelteinflüssen zur Verfügung. Zur Herstellung einer Ausnehmung bzw. Vertiefung in wenigstens einem Leiterplattenelement, welche in weiterer Folge zur Aufnahme des elektronischen Bauteils dient, wird erfindungsgemäß darüber hinaus vorgeschlagen, dass die Ausnehmung in dem wenigstens einen Leiterplattenelement durch ein Freistellen eines Teilbereichs des Leiterplattenelements nach der Verbindung von miteinander zu verbindenden Lagen des Leiterplattenelements unter Verwendung eines ein Anhaften des Teilbereichs verhindernden Materials hergestellt wird. Derartige Verfahren zum Herstellen von Ausnehmungen bzw. Vertiefungen durch Freistellen eines Teilbereichs einer mehrlagigen Leiterplatte sind für sich gesehen bekannt und können in besonders einfacher und zuverlässiger Weise im Rahmen des erfindungsgemäßen Verfahrens integriert werden.

Durch Verwendung von jeweils fertig gestellten Leiterplattenelementen zur Aufnahme des elektronischen Bauteils kann insbesondere unter Einsatz von an sich bekannten Herstellungsverfahren von Leiterplatten auf eine einzelne Bestückung von Modulen verzichtet werden, da, wie dies an sich bekannt ist, eine Mehrzahl von Leiterplattenelementen in einem gemeinsamen Trägerelement oder einem an eine Herstellungslinie von Leiterplatten angepassten Format jeweils vorgesehen bzw. aufgenommen sein kann, so dass durch ein Verbinden jeweils einer Vielzahl von in derartigen Formaten bzw. Trägerelementen aufgenommenen, vorab fertig gestellten Leiterplattenelementen in einem gemeinsam Herstellungsvorgang eine Vielzahl von derartigen Modulen, welche jeweils aus zwei vorab fertig gestellten Leiterplattenelementen und einem darin integrierten elektronischen Bauteil bestehen, zur Verfügung gestellt werden kann. Die Module werden, wie dies ebenfalls an sich bekannt ist, in nachfolgenden Be- bzw. Verarbeitungsschritten unterteilt bzw. vereinzelt. Derart lässt sich der Aufwand für eine Herstellung insbesondere einer großen Anzahl von derartigen Modulen weiter reduzieren.

Für eine einfache und zuverlässige Aufnahme eines derartig zu integrierenden elektronischen Bauteils als auch gegebenenfalls in Anpassung an die Eigenschaften eines derartig zu integrierenden elektronischen Bauteils und/oder das Einsatzgebiet derselben wird gemäß einer bevorzugten Ausführungsform vorgeschlagen, dass die Abmessungen der Ausnehmung derart gewählt werden, dass sie die Abmessungen des Bauteils in wenigstens einer Erstreckungsrichtung des Bauteils übersteigen. Somit kann nicht nur ein einfaches Anpassen bzw. eine zuverlässige und einfache Aufnahme des elektronischen Bauteils in der wenigstens einen Vertiefung bzw. Ausnehmung sichergestellt werden, sondern es kann, wie dies nachfolgend noch im Detail erörtert werden wird, ein an die Einsatzeigenschaften des elektronischen Bauteils angepasster Freiraum zur Verfügung gestellt werden.

Gemäß einer weiters bevorzugten Ausführungsform wird vorgeschlagen, dass die Abmessungen der Ausnehmung die Abmessungen des Bauteils in der wenigstens einen Erstreckungsrichtung um wenigstens 5 %, insbesondere wenigstens 15 % der entsprechenden Abmessung des Bauteils übersteigen, wobei gemäß einer weiters bevorzugten Ausführungsform vorgeschlagen wird, dass die Abmessungen der Ausnehmung derart gewählt werden, dass sie die Abmessungen des Bauteils in sämtlichen Erstreckungsrichtungen des Bauteils übersteigen. Derart lassen sich unterschiedliche elektronische Bauteile in erfindungsgemäß bereitgestellten, fertig gestellten und miteinander zu verbindenden Leiterplattenelemente aufnehmen.

Gemäß einer weiters bevorzugten Ausführungsform wird erfindungsgemäß vorgeschlagen, dass der zu integrierende elektronische Bauteil von einem Sensor, beispielsweise zur Bestimmung von Temperatur, Feuchtigkeit, Druck, Schall, Helligkeit, Beschleunigung, räumliche Lage, Zusammensetzung von gasförmigen oder flüssigen Medien, einem Hochfrequenzelement oder dgl., gebildet wird. Insbesondere aufgrund der Tatsache, dass, wie oben ausführlich erörtert, durch Bereitstellung von zwei fertig gestellten Leiterplattenelementen, von welchen wenigstens eines eine Ausnehmung bzw. Vertiefung zur Aufnahme eines zu integrierenden elektronischen Bauteils zur Verfügung stellt, wobei die Abmessungen der Ausnehmung in bevorzugter Weise die Abmessungen des aufzunehmenden elektronischen Bauteils übersteigen, kann ein derartiger elektronischer Bauteil in Form eines Sensors zur Erfassung bzw. Ermittlung einer überaus großen Vielzahl von verschiedenen Messgrößen eingesetzt und zuverlässig und sicher in eine Leiterplatte integriert werden.

Mit dem erfindungsgemäß vorgeschlagenen Verfahren gelingt es somit, unterschiedlichste Sensoren in eine Leiterplatte zu integrieren und beispielsweise im Zusammenhang mit der MEMS-Technologie zum Einsatz zu bringen.

Wie oben ausgeführt, lässt sich bei Ausbilden des zu integrierenden elektronischen Bauteils als Sensor eine unterschiedliche Vielzahl von Messgrößen ermitteln, wobei für einige der Messgrößen eine Kopplung des Sensors mit der Außenumgebung erforderlich ist. In diesem Zusammensetzung wird vorgeschlagen, dass wenigstens eine in die Ausnehmung zur Aufnahme des zu integrierenden Bauteils mündende Durchtrittsöffnung in einem Leiterplattenelement ausgebildet wird, wie dies einer weiters bevorzugten Ausführungsform der Erfindung entspricht. Derart können beispielsweise durch die erfindungsgemäß vorgesehene Durchtrittsöffnung beispielsweise gasförmige oder flüssige Medien zur Bestimmung deren Zusammensetzung und physikalischen Größen, wie beispielsweise Temperatur, Feuchtigkeit, Druck, Schall oder dgl. in den Freiraum, in welchem der Sensor unmittelbar in der Leiterplatte integriert ist, zugeführt werden.

Zur Vermeidung eines Einflusses von beispielsweise elektromagnetischer Strahlung, welche einerseits von weiteren, in der Leiterplatte integrierten Komponenten oder auch von der Außenumgebung der Leiterplatte stammen kann, wird gemäß einer bevorzugten Ausführungsform vorgeschlagen, dass die Abschirmung wenigstens teilweise von im wesentlichen vollflächigen leitenden Schichten der Leiterplattenelemente gebildet wird. Derartige im wesentlichen vollflächige leitende Schichten können hierbei nicht nur beispielsweise zum Aufbau einer elektromagnetischen Abschirmung in Form eines Faraday'schen Käfigs herangezogen werden, sondern stellen auch durch die Verhinderung eines Durchtritts von beispielsweise gasförmigen oder flüssigen Medien durch derartige Schichten eine entsprechend Abschirmung gegenüber derartigen äußeren Einflüssen zur Verfügung.

Zur Kopplung bzw. Verbindung von einzelnen leitenden Bereichen, welche beim Aufbau der einzelnen Leiterplattenelemente zur Abschirmung des zu integrierenden elektronischen Bauteils aufgenommen werden, wird zur Herstellung von einer den Bauteil im wesentlichen über seinen gesamten Umfang umgebenden Abschirmung gegenüber elektromagnetischer Strahlung gemäß einer weiters bevorzugten Ausführungsform vorgeschlagen, dass zur Abschirmung verwendete leitende Bereiche der Leiterplattenelemente zusätzlich durch leitende Kontaktierungen zwischen den leitenden Bereichen der Leiterplattenelemente verbunden werden.

Im Rahmen einer angestrebten zunehmenden Miniaturisierung von Bauteilen als auch von Leiterplattenelementen und zur weiteren Vermeidung von Störeinflüssen wird, wie oben bereits ausgeführt, oftmals darauf abgezielt, wenigstens Teile einer Auswerteeinheit von elektronischen Sensoren bzw. Bauteilen in möglichst unmittelbarer Nachbarschaft derartiger Bauteile bzw.

Sensoren anzuordnen. In diesem Zusammenhang wird gemäß einer weiters bevorzugten Ausführungsform des erfindungsgemäßen Verfahrens vorgeschlagen, dass die Auswerteelektronik für den Bauteil in dem Leiterplattenelement integriert wird, auf welchem der elektronische Bauteil abgestützt oder mit welchem der elektronische Bauteil kontaktiert wird. Durch eine derartige zusätzliche Integration der Auswerteelektronik in wenigstens eines der Leiterplattenelemente und somit in unmittelbarer Nachbarschaft des zu integrierenden elektronischen Bauteils kann beispielsweise die Auswerteelektronik unmittelbar gemeinsam mit dem Bauteil durch Aufnahme innerhalb der Abschirmung ebenfalls gegenüber Umwelteinflüssen entsprechend geschützt werden.

Für eine besonders zuverlässige und einfache Verbindung der miteinander zu verbindenden fertig gestellten Leiterplattenelemente nach Aufnahme des elektronischen Bauteils wird darüber hinaus vorgeschlagen, dass die Verbindung der Leiterplattenelemente in an sich bekannter Weise durch ein Löten, eutektisches Bonden, Thermokompressionsbonding, Diffusionslöten, unter Verwendung eines leitfähigen Klebers und/oder von leitenden bzw. leitfähigen Klebefolien oder dgl. durchgeführt wird, wie dies einer bevorzugten Ausführungsform des erfindungsgemäßen Verfahrens entspricht. Derartige Verbindungsverfahren sind im Rahmen der Herstellung von Leiterplatten für sich gesehen bekannt, so dass sie unmittelbar zum Einsatz gelangen können, ohne Herstellungsverfahren für mehrlagige Leiterplatten aufwendig modifizieren oder erweitern zu müssen. Darüber hinaus stellen dieses Verbindungsverfahren sicher, dass eine Änderung des Aufbaus der fertig gestellten Leiterplattenelemente, welche gegebenenfalls zu einer Beeinträchtigung des für die Aufnahme des elektronischen Bauteils zur Verfügung zu stellenden Freiraums führen könnte, mit Sicherheit vermieden wird.

Weiters kann eine Leiterplatte mit einem darin integrierten elektronischen Bauteil derart ausgebildet sein, dass eine teilweise Abschirmung des Bauteils in in der Ausnehmung aufgenommenem Zustand gegenüber der Außenumgebung und/oder benachbarten Teilbereichen der Leiterplatte vorgesehen ist und dass die Ausnehmung in dem wenigstens einen Leiterplattenelement durch ein Freistellen eines Teilbereichs des Leiterplattenelements nach der Verbindung von miteinander zu verbindenden Lagen des Leiterplattenelements unter Verwendung eines ein Anhaften des Teilbereichs verhindernden Materials hergestellt ist.

Derart lässt sich, wie oben bereits ausgeführt, in einfacher und zuverlässiger Weise eine Leiterplatte mit einem darin integrierten elektronischen Bauteil sowie einer damit zu koppelnden Auswerteelektronik zur Verfügung stellen, wobei insbesondere sichergestellt wird, dass selbst nach bzw. bei einem Verbinden der fertig gestellten Leiterplattenelemente keine Beeinflussung bzw. Beeinträchtigung des zur Aufnahme des elektronischen Bauteils zur Verfügung stellenden Freiraums zu befürchten ist. Zur Bereitstellung einer Abschirmung des Bauteils gegenüber äußeren Umgebungseinflüssen kann vorgesehen sein, dass eine teilweise Abschirmung des Bauteils in in der Ausnehmung aufgenommenem Zustand gegenüber der Außenumgebung und/oder benachbarten Teilbereichen der Leiterplatte vorgesehen ist. Neben einer Abschirmung beispielsweise gegenüber elektromagnetischer Strahlung insbesondere durch Einsatz von entsprechenden leitenden Materialien zum Aufbau eines Faraday'schen Käfigs kann in speziellen Einsatzfällen eines derartigen zu integrierenden elektronischen Bauteils bzw. Sensors eine Abschirmung und Abdichtung gegenüber gasförmigen oder flüssigen Medien erforderlich sein, wobei beispielsweise bei der Herstellung von Leiterplatten eingesetzte Kunststoffmaterialien gegebenenfalls nicht die erforderliche Abschirmwirkung gegenüber derartigen Substanzen aufweisen. Zur Erzielung einer entsprechend hermetisch dichten Abdichtung auch im Bereich von Kontaktierungen des zu integrierenden elektronischen Bauteils, wo insbesondere vollflächig leitende bzw. metallische Materialien, welche gegebenenfalls die erforderlichen Abdichteigenschaften aufweisen würden, zur Vermeidung von Kürzschlüssen oder dgl. nicht eingesetzt werden können, wird vorgeschlagen, dass im Bereich von Kontaktierungen des zu integrierenden Bauteils eine Schicht aus einem hermetisch dichten, nicht leitenden Material in einem Leiterplattenelement eingebettet wird und eine Kontaktierung des Bauteils über durch die hermetisch dichtende Schicht ausgebildete Sacklöcher vorgenommen wird, welche mit einem leitenden Material, einer Plattierung oder dgl. gefüllt sind. Derartige hermetisch dichte und insbesondere nicht leitende Materialien lassen sich ebenfalls im Rahmen der Herstellung der Leiterplattenelemente in einfacher Weise in diese integrieren. Zur Herstellung einer Ausnehmung bzw. Vertiefung in wenigstens einem Leiterplattenelement, welche in weiterer Folge zur Aufnahme des elektronischen Bauteils dient, wird vorgeschlagen, dass die Ausnehmung in dem wenigstens einen Leiterplattenelement durch ein Freistellen eines Teilbereichs des Leiterplattenelements nach der Verbindung von miteinander zu verbindenden Lagen des Leiterplattenelements unter Verwendung eines ein Anhaften des Teilbereichs verhindernden Materials hergestellt ist.

Zur einfachen Einpassung des Bauteils als auch zur Anpassung an gegebenenfalls unterschiedliche Einsatzzwecke des zu integrierenden elektronischen Bauteils wird für eine derartige Leiterplatte bevorzugt vorgeschlagen, dass die Abmessungen der Ausnehmung zur Aufnahme des elektronischen Bauteils in wenigstens einer Erstreckungsrichtung des Bauteils die Abmessungen desselben übersteigen.

Weiters können die Abmessungen der Ausnehmung die Abmessungen des Bauteils in wenigstens einer Erstreckungsrichtung um wenigstens 5 %, insbesondere wenigstens 15 % der Abmessungen des Bauteils übersteigen, wobei die Abmessungen der Ausnehmung derart gewählt sein können, dass sie die Abmessungen des Bauteils in sämtlichen Erstreckungsrichtungen des Bauteils übersteigen. Derart lässt sich ein entsprechend großer Freiraum zur Aufnahme des elektronischen Bauteils zur Verfügung stellen.

Zur Ermittlung unterschiedlicher Messgrößen bzw. Werte unter Verwendung einer derartigen Leiterplatte wird darüber hinaus vorgeschlagen, dass der zu integrierende elektronische Bauteil von einem Sensor, beispielsweise zur Bestimmung von Temperatur, Feuchtigkeit, Druck, Schall, Helligkeit, Beschleunigung, räumliche Lage, Zusammensetzung von gasförmigen oder flüssigen Medien, einem Hochfrequenzelement oder dgl., gebildet ist.

Zur Ermittlung von unterschiedlichen physikalischen und/oder chemisch-physikalischen Eigenschaften oder Parametern von zu untersuchenden gasförmigen oder flüssigen Medien wird darüber hinaus vorgeschlagen, dass wenigstens eine in das Innere der Ausnehmung zur Aufnahme des Bauteils mündende Durchtrittsöffnung vorgesehen ist.

Insbesondere zur Abschirmung gegenüber elektromagnetischer Strahlung kann vorgesehen sein, dass die Abschirmung wenigstens teilweise von im wesentlichen vollflächigen leitenden Schichten der Leiterplattenelemente gebildet ist. Eine Integration von derartigen, im wesentlichen vollflächigen leitenden Schichten in die Leiterplattenelemente ist hierbei insbesondere bei der Herstellung von mehrlagigen Leiterplatten in einfacher und zuverlässiger Weise möglich.

Zur Erzielung einer den elektronischen Bauteil im wesentlichen über den gesamten Umfang umgebenden Abschirmung wird darüber hinaus vorgeschlagen, dass zur Abschirmung verwendete leitende Bereiche der Leiterplattenelemente zusätzlich durch leitende Kontaktierungen zwischen den leitenden Bereichen der Leiterplattenelemente verbunden sind. Derartige leitende Kontaktierungen lassen sich durch bei der Herstellung einer Leiterplatte übliche und bekannte Schritte in einfacher und zuverlässiger Weise herstellen.

Wie oben bereits ausgeführt, ist zur Vereinfachung und Unterstützung der Aufnahme und Auswertung der von den elektronischen Bauteilen bzw. Sensoren bereitgestellten Messwerte als auch zur weiteren Miniaturisierung eine möglichst geringe räumliche Entfernung zwischen dem Sensor bzw. dem elektronischen Bauteil und einer Auswerteelektronik erwünscht bzw. erforderlich. Hiebei wird vorgeschlagen, dass die Auswerteelektronik für den Bauteil in dem Leiterplattenelement integriert ist, auf welchem der elektronische Bauteil abgestützt oder mit welchem der elektronische Bauteil kontaktiert ist.

Zur Erzielung einer zuverlässigen Verbindung der Leiterplattenelemente, welche gegebenenfalls auch erwünschte Abdichteigenschaften zur Verfügung stellt, wird darüber hinaus vorgeschlagen, dass die Verbindung der Leiterplattenelemente in an sich bekannter Weise durch ein Löten, eutektisches Bonden, Thermokompressionsbonding, Diffusionslöten, unter Verwendung eines leitfähigen Klebers und/oder von leitenden bzw. leitfähigen Klebefolien oder dgl. gebildet ist.

Die Erfindung wird nachfolgend anhand von in der beiliegenden Zeichnung schematisch dargestellten Ausführungsbeispielen näher erläutert.

In dieser zeigen:
Fig. 1 eine schematische Darstellung einer Leiterplatte mit einem darauf angeordneten elektronischen Bauteil gemäß dem Stand der Technik;
Fig. 2 eine schematische Darstellung einer Leiterplatte mit einem darin integrierten elektronischen Bauteil;
Fig. 3 in einer zu Fig. 2 ähnlichen Darstellung eine abgewandelte Ausführungsform einer Leiterplatte, wobei zusätzlich eine Auswerteelektronik in unmittelbarer Nähe des integrierten elektronischen Bauteils vorgesehen ist;
Fig. 4 in einer wiederum zu Fig. 2 ähnlichen Darstellung eine weitere abgewandelte Ausführungsform einer Leiterplatte, wobei eine Anordnung des Bauteils in der in einem Leiterplattenelement vorgesehenen Ausnehmung erfolgt; und
Fig. 5 eine schematische Darstellung einer Ausführungsform einer erfindungsgemäß hergestellten Leiterplatte, wobei eine hermetische Abdichtung auch im Bereich von Kontakten des zu integrierenden elektronischen Bauteils vorgesehen ist.

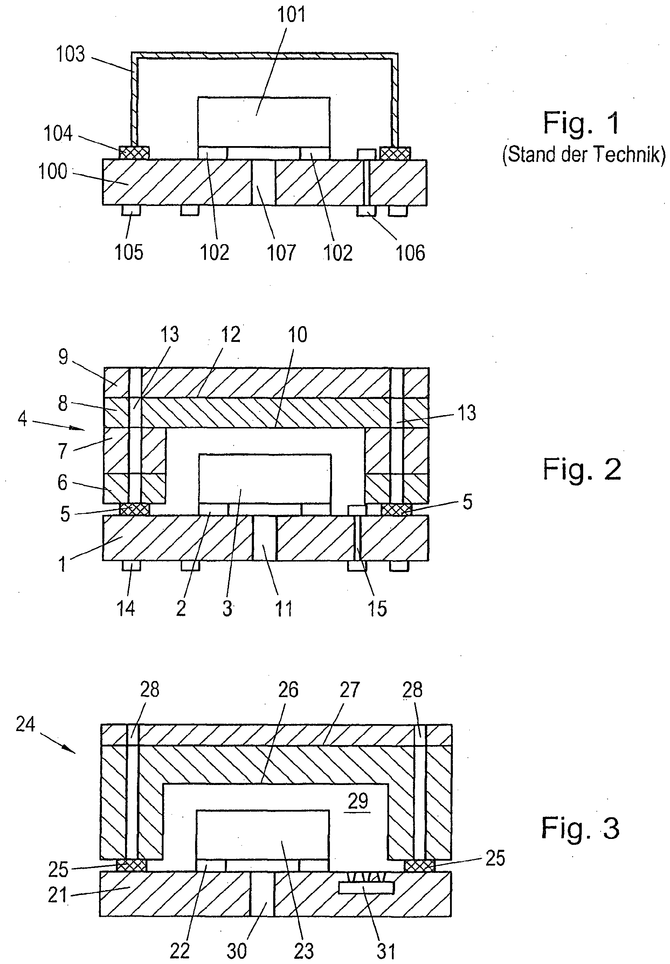

Bei der Ausbildung gemäß dem Stand der Technik, wie sie in Fig. 1 schematisch angedeutet ist, ist ersichtlich, dass auf einem Leiterplattenelement 100, welches beispielsweise aus einer nicht näher dargestellten Vielzahl von verschiedenen Schichten bzw. Lagen bestehen kann, ein elektronischer Bauteil 101 angeordnet ist, wobei lediglich zwei Kontakte 102 schematisch angedeutet sind. Dieser elektronische Bauteil 101 wird beispielsweise von einem Mikrofon gebildet, wobei zur Erzielung einer entsprechenden Abschirmung des auf dem Leiterplattenelement 100 angeordneten elektronischen Bauteils ein metallischer Käfig 103 angedeutet ist, welcher mit nicht näher dargestellten leitenden Elementen über Verbindungen 104 verbunden wird. Weitere Kontaktierungen der Leiterplatte bzw. strukturierte leitende Elemente derselben sind schematisch mit 105 und 106 angedeutet.

Beim Stand der Technik erfolgt somit eine Anordnung eines zusätzlich zu schützenden bzw. abzuschirmenden elektronischen Bauteils 101 auf einer Oberfläche einer Leiterplatte, wobei im vorliegenden Fall eines Einsatzes des elektronischen Bauteils 101 als Mikrofon ein Loch bzw. eine Durchtrittsöffnung 107 für den durch das Mikrofon 101 aufzunehmenden Schall angedeutet ist. Es ist unmittelbar einsichtig, dass bei dieser bekannten Ausführungsform nicht nur ein erheblicher zusätzlicher Aufwand für die nachträgliche Herstellung der beispielsweise von einem Metallkäfig gebildeten Abschirmung 103 erforderlich ist, sondern auch keineswegs eine entsprechend geschützte bzw. sichere Aufnahme des elektronischen Bauteils 101 gewährleistet werden kann.

Bei der in Fig. 2 dargestellten Ausführungsform ist ähnlich wie beim Stand der Technik gemäß Fig. 1 ein insbesondere mehrlagiges Leiterplattenelement 1 vorgesehen, auf welchen wiederum über schematisch angedeutete Kontakte 2 ein elektronischer Bauteil 3 festgelegt ist.

Mit dem vorab fertig gestellten Leiterplattenelement 1 wird ein zweites Leiterplattenelement 4 über Verbindungen 5, auf welche näher nachfolgend im Detail eingegangen wird, verbunden, wobei bei dem zweiten Leiterplattenelement 4 eine Vielzahl von unterschiedlichen Schichten bzw. Lagen 6, 7, 8 und 9 ersichtlich bzw. angedeutet ist. Darüber hinaus ist das ebenfalls vorab fertig gestellte Leiterplattenelement 4 mit einer Ausnehmung bzw. Vertiefung 10 ausgebildet, deren Abmessung in der in Fig. 2 dargestellten Ausführungsform die Abmessungen des elektronischen Bauteils 3 in sämtlichen Erstreckungsrichtungen übersteigt, wobei die Abstände bzw. der Freiraum zwischen dem Bauteil 3 und den Begrenzungswänden der Ausnehmung bzw. Vertiefung 10 insbesondere zur Verdeutlichung der Darstellung nicht maßstabsgetreu und übermäßig groß dargestellt sind.

Bei einem Einsatz des Bauteils 3 wiederum als Mikrofon ist auch in dem Leiterplattenelement 1 eine Durchtrittsöffnung bzw. ein Schalloch 11 ähnlich wie bei der Ausführungsform gemäß Fig. 1 vorgesehen.

Zur Erzielung einer entsprechenden Abschirmung des Bauteils bzw. Mikrofons 3 gegenüber elektromagnetischer Strahlung wird ein den Bauteil 3 im wesentlichen vollständig umgebender metallischer Käfig durch eine im wesentlichen vollflächige Lage 12 aus leitendem Material, welches unmittelbar eine Trennschicht bzw. Lage des mehrlagigen vorab fertig gestellten Leiterplattenelements 4 darstellt sowie im Bereich der Kontaktierungen bzw. Verbindungen 5 durch Kontaktierungen 13 gebildet. Derartige Kontaktierungen 13 werden durch bei der Herstellung von Leiterplatten bekannte Durchtrittsöffnungen gebildet, welche beispielsweise ebenfalls mit einem leitenden Material gefüllt bzw. zumindest damit plattiert werden. Bei Vorsehen einer Verbindung 5 aus ebenfalls leitendem Material, beispielsweise einer Lötverbindung 5, ergibt sich bei einem Verbinden der beiden Leiterplattenelemente 1 und 4 nach einer Anordnung des elektronischen Bauteils bzw. Sensors 3 unmittelbar eine zuverlässige Abschirmung, welche in die Leiterplattenelemente 1 bzw. 4 integriert ist.

Bei Einbettung eines Mikrofons 3 als zu integrierender Bauteil lassen sich beispielsweise auch Klangqualitäten des Bauteils durch Verzicht auf die getrennt anzuordnende metallische Abschirmung wie beim Stand der Technik gemäß Fig. 1 und die Einbettung des Bauteils 3 in die vorgefertigten Leiterplattenelemente 1 bzw. 4 erzielen.

Ebenfalls wie bei der Ausführungsform gemäß dem Stand der Technik, wie sie in Fig. 1 dargestellt ist, sind auch bei dem Leiterplattenelement 1 zusätzliche Strukturen bzw. Kontakte 14 und 15 angedeutet.

Bei einer Ausbildung gemäß Fig. 3 ist ähnlich wie bei der Ausführungsform gemäß Fig. 2 wiederum ein vorab fertig gestelltes Leiterplattenelement 21 vorgesehen, auf welchem abgestützt über Kontakte 22 ein elektronischer Bauteil 23 angeordnet ist.

Mit dem Leiterplattenelement 1 wird ein zweites vorab fertig gestelltes Leiterplattenelement 24 verbunden, welches ebenfalls von einem mehrlagigen Leiterplattenelement gebildet ist, wobei zur Vereinfachung derartige, an sich bekannte mehrfache Schichten bzw. Lagen in Fig. 3 nicht neuerlich dargestellt sind.

Ähnlich wie bei der vorangehenden Ausführungsform ist wiederum eine Verbindung 25 zwischen den Leiterplattenelementen 21 und 24 vorgesehen, wobei der elektronische Bauteil 23 in einer wiederum im Leitenplattenelement 24 vorgesehenen Ausnehmung bzw. Vertiefung 26 angeordnet wird, deren gegenüber den Abmessungen des Bauteils 23 vergrößerte Abmessungen zur Verdeutlichung wiederum übertrieben dargestellt sind.

Für eine bei Verwendung beispielsweise als Mikrofon 23 wiederum vorzusehende zusätzliche Abschirmung ist eine im wesentlichen vollflächige Lage aus einem leitenden metallischen Material im Leiterplattenelement 24 mit 27 bezeichnet, wobei zur Vervollständigung der Abschirmung ähnlich wie bei der vorangehenden Ausführungsform wiederum Durchtrittsöffnungen 28 angedeutet sind, welche bei bzw. nach einem Füllen bzw. zumindest Plattieren mit einem leitenden Material und bei Vorsehen einer Verbindung 25 aus einem leitenden Material wiederum eine entsprechende, den elektronischen Bauteil 23 umgebende Abschirmung zur Verfügung stellen.

Eine Durchtrittsöffnung zu dem durch die Ausnehmung 26 definierten Freiraum 29, in welchem der Bauteil bzw. Sensor 23 angeordnet bzw. aufgenommen oder integriert ist, ist mit 30 angedeutet.

Darüber hinaus ist bei der in Fig. 3 dargestellten Ausführungsform vorgesehen, dass in unmittelbarer räumlicher Nähe und insbesondere integriert in das Leiterplattenelement 21 eine Auswerteelektronik 31 für den Bauteil 23 vorgesehen ist, so dass im Hinblick auf eine Miniaturisierung eines derartigen modulartig aufgebauten Sensors, welcher unmittelbar in eine Leiterplatte integriert bzw. integrierbar ist, eine Aufnahme und/oder Auswertung der von dem Sensor 23 ermittelten Messgrößen bzw. Messwerte erzielbar ist.

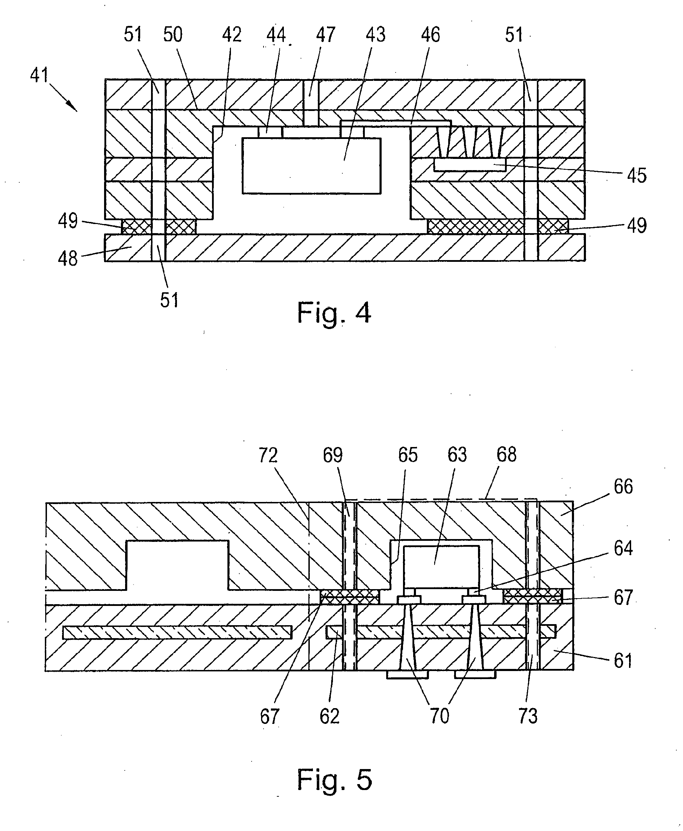

Bei der in Fig. 4 dargestellten weiteren abgewandelten Ausführungsform ist ein wiederum aus mehreren Lagen bestehendes Leiterplattenelement 41 mit einer Ausnehmung bzw. Vertiefung 42 versehen, wobei ein elektronischer Bauteil 43 unmittelbar über Kontakte 44 in dieser Ausnehmung 42 des Leiterplattenelements 41 festgelegt ist. Ähnlich wie bei der vorangehenden Ausführungsform ist in das Leiterplattenelement 41 wiederum eine Auswerteelektronik 45 in unmittelbarer Nähe des Bauteils 43 integriert, wobei eine Kontaktierung zwischen dem Bauteil 43 und der Auswerteelektronik schematisch mit 46 angedeutet ist. Auch bei der Ausführungsform gemäß Fig. 4 ist eine Durchtrittsöffnung 47 für eine Verbindung des Sensors bzw. Bauteils 43 mit der Außenumgebung vorgesehen.

Mit dem Leiterplattenelement 41 wird ähnlich wie bei den vorangehenden Ausführungsformen ein weiteres Leiterplattenelement 48 über Verbindungen 49 verbunden bzw. gekoppelt, wobei zur Herstellung einer Abschirmung ähnlich wie bei den vorangehenden Ausführungsformen neben einer Schicht bzw. Lage 50 aus einem leitenden Material neuerlich Durchtrittsöffnungen 51 mit einer entsprechenden metallischen Plattierung oder dgl. versehen sind bzw. werden.

Bei der schematischen Darstellung gemäß Fig. 5 ist ersichtlich, dass, wie bei der Herstellung von Leiterplatten an sich bekannt, üblicherweise eine große Vielzahl von ähnlichen Elementen in einem gemeinsamen Träger oder einem entsprechend großen Format hergestellt wird, wobei nach einer Fertigstellung der einzelnen Leiterplatten diese in einzelne Module bzw. Elemente unterteilt werden.

Darüber hinaus ist bei der Ausführungsform gemäß Fig. 5 angedeutet, dass im Gegensatz zu den vorangehenden Ausführungsformen gemäß Fig. 2 bis 4 eine im wesentlichen hermetische Abdichtung des aufzunehmenden elektronischen Bauteils vorgesehen sein soll.

Zu diesem Zweck ist in einem ersten fertig gestellten Leiterplattenelement 61, welches wiederum aus einer Mehrzahl von Schichten bzw. Lagen hergestellt ist, welche der Einfachheit halber nicht im Detail gezeigt sind, zusätzlich eine Schicht bzw. Lage 62 aus einem hermetisch dichtenden Material, wie beispielsweise Glas, Keramik oder dgl. vorgesehen bzw. integriert. Ähnlich wie bei den vorangehenden Ausführungsformen wird im Leiterplattenelement 61 ein elektronischer Bauteil bzw. Sensor 63 über schematische Kontakte 64 angeordnet, wobei der elektronische Bauteil 63 in einer Ausnehmung 65 eines weiteren Leiterplattenelements 66 angeordnet bzw. integriert wird. Eine Verbindung zwischen den Leiterplattenelementen 61 und 66 erfolgt über schematisch angedeutete Verbindungen 67.

Im Gegensatz zu den vorangehenden Ausführungsformen ist bei der in Fig. 5 dargestellten Ausbildung eine hermetische Abdichtung des Bauteils bzw. Sensors 63 gegenüber der Außenumgebung erforderlich, wobei neben der Abdichtung aus dem hermetisch dichten Material 62 eine Plattierung 68 im Leiterplattenelement 66 vorgesehen ist, wobei sich die Plattierung auch in entsprechende Durchtrittslöcher bzw. Durchtrittsöffnungen 69 im Bereich der Verbindungen 67 erstreckt. Durch Vorsehen einer durchgehenden Plattierung bzw. vollflächigen Materialschicht aus einem metallischen Material wird eine entsprechende Dichtheit zur Verfügung gestellt, welche durch die Abdichtung aus dem Material 62 eine vollflächige Ummantelung bzw. Abschirmung des Bauteils 63 ermöglicht.

Im Bereich des hermetisch dichten Materials 62 erfolgt eine Durchkontaktierung 70 durch entsprechende Bohrungen bzw. Sacklöcher, welche das hermetisch dichte Material 62 durchdringen. Derart lässt sich auch im Bereich der voneinander zu trennenden Kontakte eine entsprechende hermetische Abdichtung des Bauteils 63 zur Verfügung stellen.

Im Leiterplattenelement 61 sind darüber hinaus Schlitze bzw. Bohrungen oder Durchbrechungen 73 neben den Durchkontaktierungen 70 und das Material 62 durchdringend vorgesehen, welche beispielsweise ähnlich wie die Löcher 69 insbesondere galvanisch plattiert sind, um neben einer elektromagnetischen Abschirmung die hermetische Abschirmung zu vervollständigen.

In Fig. 5 ist darüber hinaus nach der Fertigstellung der einzelnen Module eine Trennlinie 72 zur Unterteilung von benachbarten Modulen vorgesehen, wobei für das benachbarte Modul lediglich die Leiterplattenelemente 61 bzw. 66 schematisch angedeutet sind.

Abweichend von den gezeigten Darstellungen ist bekannt, dass derartige elektronische Bauteile eine überaus große Vielzahl von Kontakten bzw. Kontaktstellen aufweisen, wobei in den Darstellungen zur Vereinfachung derselben jeweils im wesentlichen lediglich zwei Kontakte 2, 22, 44 bzw. 64 angedeutet sind.

Darüber hinaus ist insbesondere abhängig von dem Einsatz- bzw. Verwendungszweck des elektronischen Bauteils 3, 23, 43 bzw. 63 nicht unbedingt erforderlich, wie dies in den Darstellungen insbesondere aus Gründen der Verdeutlichung gezeigt ist, dass die von den jeweiligen Ausnehmungen bzw. Vertiefungen 10, 26, 42 bzw. 65 gebildeten Freiräume die Abmessungen des jeweils aufzunehmenden elektronischen Bauteils 3, 23, 43 bzw. 63 in dem dargestellten Ausmaß übersteigen.

Es kann auch vorgesehen sein, dass die Abmessungen der jeweiligen Ausnehmung bzw. Vertiefung 10, 26, 42 bzw. 65 im wesentlichen an die Abmessungen des aufzunehmenden bzw. zu integrierenden Bauteils 3, 23, 43 bzw. 63 angepasst sind, so dass der Bauteil im wesentlichen passgenau in einer derartigen Ausnehmung bzw. Vertiefung aufgenommen wird. Wesentlich ist, dass durch Bereitstellung von jeweils fertig gestellten Leiterplattenelementen 1, 4, 21, 24, 41, 48 bzw. 61 und 66 die Abmessungen des durch die Ausnehmungen 10, 26, 42 bzw. 65 definierten Freiraums unverändert beibehalten werden.

Für eine Verbindung 5, 25, 49, 67 der miteinander zu verbindenden Leiterplattenelemente 1, 4, 21, 24, 41, 48 bzw. 61 und 66 kann neben einer Lötverbindung, wie sie oben angeführt ist, auch eine Verbindung über ein eutektisches Bonden, ein Thermokompressionsbonding, ein Diffusionslöten oder eine Verbindung unter Verwendung eines leitfähigen Klebers und/oder von leitenden bzw. leitfähigen Klebefolien durchgeführt werden, falls eine Abschirmung von leitenden Materialien erforderlich sein sollte. Sollte eine derartige durchgehende Abschirmung des Bauteils aus leitendem Material beispielsweise unter Ausbildung eines Faraday'schen Käfigs nicht erforderlich sein, können auch beispielsweise Klebeverbindungen aus nicht leitfähigem Material vorgesehen sein.

Neben einer Ausbildung des zu integrierenden bzw. aufzunehmenden elektronischen Bauteils 3, 23 bzw. 43 beispielsweise als Mikrofon, wobei hiefür jeweils eine Durchtrittsöffnung 11, 30 bzw. 47 in Form eines Schallochs zur Verfügung gestellt wird, können derartige Bauteile auch zur Feststellung von anderen physikalischen Größen, wie beispielsweise Temperatur, Feuchtigkeit, Druck, Helligkeit oder allgemein einer Zusammensetzung von gasförmigen oder flüssigen Medien herangezogen werden. Alternativ kann der elektronische Bauteil auch von einem Hochfrequenzelement gebildet sein.

Bei einer Ausführungsform gemäß Fig. 5, bei welcher eine im wesentlichen hermetische Abdichtung zur Verfügung gestellt wird, kann beispielsweise in dem von der Ausnehmung zur Verfügung gestellten Freiraum ein Beschleunigungssensor oder Lagesensor integriert sein oder von einem anderen Sensor gebildet werden, bei welchem eine Abschirmung gegenüber Umwelteinflüssen bzw. Einflüssen aus der Außenumgebung sicher vermieden werden muss.

Neben einer Abschirmung des Bauteils bzw. Sensors 3, 23, 43 bzw. 63 gegenüber Umwelteinflüssen kann die Abschirmung auch zur Absicherung von weiteren Elementen bzw. Bestandteilen eines in den Zeichnungen nicht näher dargestellten Bereichs einer Leiterplatte herangezogen werden, falls beispielsweise eine Feststellung der Beschaffenheit von aggressiven Medien im Bereich des elektronischen Bauteils 63 durchgeführt werden sollte.

Insgesamt erfolgt die Einbettung der Bauteile bzw. Sensoren 3, 23, 43 bzw. 63 unter Verwendung von in der Herstellung von Leiterplatten allgemein bekannten Verfahrensschritten.

## Patentansprüche

1. Verfahren zur Integration eines elektronischen Bauteils in eine Leiterplatte, umfassend die folgenden Schritte:
- Bereitstellen von zwei fertig gestellten, und insbesondere aus einer Mehrzahl von miteinander verbundenen Lagen bzw. Schichten (6, 7, 8) bestehenden Leiterplattenelementen (1, 4, 21, 24, 41, 48, 61, 66), wobei wenigstens ein Leiterplattenelement (4, 24, 41, 66) eine Ausnehmung bzw. Vertiefung (10, 26, 42, 65) aufweist,
- Anordnen des zu integrierenden Bauteils (3, 23, 43, 63) auf einem der Leiterplattenelemente oder in der Ausnehmung des wenigstens einen Leiterplattenelements, und
- Verbinden der Leiterplattenelemente (1, 4, 21, 24, 41, 48, 61, 66) unter Aufnahme des Bauteils (3, 23, 43, 63) in der Ausnehmung (10, 26, 42, 65),
wobei in der Leiterplatte eine Auswerteelektronik (31, 45) für den Bauteil (23, 43) integriert wird und wobei der elektronische Bauteil (3, 23, 43, 63) in in der Ausnehmung (10, 26, 42, 65) aufgenommenem Zustand gegenüber der Außenumgebung der zwei Leiterplattenelemente (1, 4, 21, 24, 41, 48, 61, 66) und/oder benachbarten Bereichen der Leiterplattenelemente abgeschirmt wird und eine Kontaktierung des Bauteils (63) über durch eine hermetisch dichtende Schicht (62) ausgebildete Sacklöcher (70) vorgenommen wird, welche mit einem leitenden Material, einer Plattierung oder dgl. gefüllt werden, **dadurch gekennzeichnet, dass** im Bereich von Kontaktierungen (64) des zu integrierenden Bauteils (63) die Schicht aus einem hermetisch dichten, nicht leitenden Material (62) in einem Leiterplatten-element (61) eingebettet wird und dass die Ausnehmung (65) in dem wenigstens einen Leiterplattenelement (66) durch ein Freistellen eines Teilbereichs des Leiterplattenelements nach der Verbindung von miteinander zu verbindenden Lagen des Leiterplattenelements unter Verwendung eines ein Anhaften des Teilbereichs verhindernden Materials hergestellt wird.

2. Verfahren nach Anspruch 1, **dadurch gekennzeichnet, dass** die Abmessungen der Ausnehmung (10, 26, 42, 65) derart gewählt werden, dass sie die Abmessungen des Bauteils (3, 23, 43, 63) in wenigstens einer Erstreckungsrichtung des Bauteils (3, 23, 43, 63) übersteigen.

3. Verfahren nach Anspruch 2, **dadurch gekennzeichnet, dass** die Abmessungen der Ausnehmung (10, 26, 42, 65) die Abmessungen des Bauteils (3, 23, 43, 63) in der wenigstens einen Erstreckungsrichtung um wenigstens 5 %, insbesondere wenigstens 15 % der entsprechenden Abmessung des Bauteils (3, 23, 43, 63) übersteigen.

4. Verfahren nach Anspruch 2 oder 3, **dadurch gekennzeichnet, dass** die Abmessungen der Ausnehmung (10, 26, 42, 65) derart gewählt werden, dass sie die Abmessungen des Bauteils (3, 23, 43, 63) in sämtlichen Erstreckungsrichtungen des Bauteils (3, 23, 43, 63) übersteigen.

5. Verfahren nach einem der Ansprüche 1 bis 4, **dadurch gekennzeichnet, dass** der zu integrierende elektronische Bauteil (3, 23, 43, 63) von einem Sensor, beispielsweise zur Bestimmung von Temperatur, Feuchtigkeit, Druck, Schall, Helligkeit, Beschleunigung, räumliche Lage, Zusammensetzung von gasförmigen oder flüssigen Medien, einem Hochfrequenzelement oder dgl., gebildet wird.

6. Verfahren nach einem der Ansprüche 1 bis 5, **dadurch gekennzeichnet, dass** wenigstens eine in die Ausnehmung (10, 26, 42) zur Aufnahme des zu integrierenden Bauteils (3, 23, 43) mündende Durchtrittsöffnung (11, 30, 47) in einem Leiterplattenelement (1, 21, 41) ausgebildet wird.

7. Verfahren nach einem der Ansprüche 1 bis 6, **dadurch gekennzeichnet, dass** die Abschirmung wenigstens teilweise von im wesentlichen vollflächigen leitenden Schichten (12, 27, 50) der Leiterplattenelemente (4, 24, 41) gebildet wird.

8. Verfahren nach Anspruch 7, **dadurch gekennzeichnet, dass** zur Abschirmung verwendete leitende Bereiche (12, 27, 50, 68) der Leiterplattenelemente (4, 24, 41, 66) zusätzlich durch leitende Kontaktierungen (13, 28, 51, 69, 73) zwischen den leitenden Bereichen der Leiterplattenelemente verbunden werden.

9. Verfahren nach einem der Ansprüche 1 bis 8, **dadurch gekennzeichnet, dass** die Auswerteelektronik (31, 45) für den Bauteil (23, 43) in dem Leiterplattenelement (21, 41) integriert wird, auf welchem der elektronische Bauteil (23, 43) abgestützt oder mit welchem der elektronische Bauteil kontaktiert wird.

10. Verfahren nach einem der Ansprüche 1 bis 9, **dadurch gekennzeichnet, dass** die Verbindung (5, 25, 49, 67) der Leiterplattenelemente (1, 4, 21, 24, 41, 48, 61, 66) in an sich bekannter Weise durch ein Löten, eutektisches Bonden, Thermokompressionsbonding, Diffusionslöten, unter Verwendung eines leitfähigen Klebers und/oder von leitenden bzw. leitfähigen Klebefolien oder dgl. durchgeführt wird.

## Claims

1. A method for integrating an electronic component into a printed circuit board, comprising the following the steps of:
- providing two completed printed circuit board elements (1, 4, 21, 24, 41, 48, 61, 66), which more particularly consist of a plurality of interconnected layers or plies (6, 7, 8), wherein at least one printed circuit board element (4, 24, 41, 66) comprises a cutout or depression (10, 26, 42, 65);
- arranging the component (3, 23, 43, 63) to be integrated on one of the printed circuit board elements or in the cutout of the at least one printed circuit board element; and
- connecting the printed circuit board elements (1, 4, 21, 24, 41, 48, 61, 66) with the component (3, 23, 43, 63) being accommodated in the cutout (10, 26, 42, 65),
wherein evaluation electronics (31, 45) for the component (23, 43) is integrated in the printed circuit board, and wherein the electronic component (3, 23, 43, 63), in its state accommodated in the cutout (10, 26, 42, 65), is shielded from the external environment of the two printed circuit board elements (1, 4, 21, 24, 41, 48, 61, 66) and/or neighboring regions of the printed circuit board elements and a contact connection of the component (63) is realized by blind holes (70) formed through a hermetically sealing layer (62) and filled with a conductive material, a plating or the like, **characterized in that** in the region of contact connections (64) of the component (63) to be integrated, the layer of a hermetically tight, nonconducting material (62) is embedded in a printed circuit board element (61) and that the cutout (65) is produced in the at least one printed circuit board element (66) by clearing a partial region of the printed circuit board element after having connected printed circuit board element layers to be connected, using a material preventing the adhesion of said partial region.

2. A method according to claim 1, **characterized in that** the dimensions of the cutout (10, 26, 42, 65) are selected to exceed the dimensions of the component (3, 23, 43, 63) in at least one direction of extension of the component (3, 23, 43, 63).

3. A method according to claim 2, **characterized in that** the dimensions of the cutout (10, 26, 42, 65) exceed the dimensions of the component (3, 23, 43, 63) in the at last one direction of extension by at least 5%, in particular at least 15%, of the respective dimension of the component (3, 23, 43, 63).

4. A method according to claim 2 or 3, **characterized in that** the dimensions of the cutout (10, 26, 42, 65) are selected to exceed the dimensions of the component (3, 23, 43, 63) in any direction of extension of the component (3, 23, 43, 63).

5. A method according to any one of claims 1 to 4, **characterized in that** the electronic component (3, 23, 43, 63) to be integrated is formed by a sensor, for instance for determining the temperature, moisture, pressure, sound, brightness, acceleration, spatial position, composition of gaseous or liquid media, a high-frequency element or the like.

6. A method according to any one of claims 1 to 5, **characterized in that** at least one passage opening (11, 30, 47) running into the cutout (10, 26, 42) for accommodating the component (3, 23, 43) to be integrated is formed in a printed circuit board element (1, 21, 41).

7. A method according to any of the claims 1 to 6, **characterized in that** shielding is at least partially provided by substantially full-surface, conducting layers (12, 27, 50) of the printed circuit board elements (4, 24, 41) .

8. A method according to claim 7, **characterized in that** conducting regions (12, 27, 50, 68) of the printed circuit board elements (4, 24, 41, 66) used for shielding are additionally connected by conducting contact connections (13, 28, 51, 69, 73) between the conducting regions of the printed circuit board elements.

9. A method according to any one of claims 1 to 8, **characterized in that** the evaluation electronics (31, 45) for the component (23, 43) is integrated in the printed circuit board element (21, 41) on which the electronic component (23, 43) is supported, or to which the electronic component is contact-connected.

10. A method according to any one of claims 1 to 9, **characterized in that** the connection (5, 25, 49, 67) of the printed circuit board elements (1, 4, 21, 24, 41, 48, 61, 66) in a manner known per se is performed by soldering, eutectic bonding, thermocompression bonding, diffusion soldering, using a conductive adhesive and/or conducting or conductive adhesive films or the like.

## Revendications

1. Procédé pour l'intégration d'un composant électronique dans une carte de circuits imprimés, comprenant les étapes suivantes :
- préparation de deux éléments de carte de circuits imprimés (1, 4, 21, 24, 41, 48, 61, 66) préfabriqués et en particulier constitués d'une pluralité de couches ou strates (6, 7, 8) assemblées, au moins un élément de carte de circuits imprimés (4, 24, 41, 66) présentant un logement ou un décrochement (10, 26, 42, 65),
- placement du composant (3, 23, 43, 63) à intégrer sur un des éléments de carte de circuits imprimés ou dans le logement de l'au moins un élément de carte de circuits imprimés, et
- assemblage des éléments de carte de circuits imprimés (1, 4, 21, 24, 41, 48, 61, 66) en recevant le composant (3, 23, 43, 63) dans le logement (10, 26, 42, 65),
dans la carte de circuits imprimés, une électronique d'évaluation (31, 45) pour le composant (23, 43) étant intégrée et le composant (3, 23, 43, 63) électronique, dans un état reçu dans le logement (10, 26, 42, 65), étant protégé contre l'environnement extérieur des deux éléments de carte de circuits imprimés (1, 4, 21, 24, 41, 48, 61, 66) et/ou de zones voisines des éléments de carte de circuits imprimés et un contact du composant (63) étant opéré via des trous borgnes (70) réalisés par une strate (62) hermétiquement étanche, lesquels sont remplis avec un matériau conducteur, un revêtement ou similaire, **caractérisé en ce que**, dans la zone des contacts (64) du composant (63) à intégrer, la strate (62) de matériau non conducteur hermétiquement étanche est incorporée dans un élément de carte de circuits imprimés (61) et que le logement (65) est produit dans l'au moins un élément de carte de circuits imprimés (66) par une libération d'une zone partielle de l'élément de carte de circuits imprimés après l'assemblage de couches à assembler entre elles de l'élément de carte de circuits imprimés en utilisant un matériau empêchant une adhérence de la zone partielle.

2. Procédé selon la revendication 1, **caractérisé en ce que** les dimensions du logement (10, 26, 42, 65) sont choisies de sorte qu'elles excèdent les dimensions du composant (3, 23, 43, 63) dans au moins une direction d'extension du composant (3, 23, 43, 63).

3. Procédé selon la revendication 2, **caractérisé en ce que** les dimensions du logement (10, 26, 42, 65) excèdent les dimensions du composant (3, 23, 43, 63) dans l'au moins une direction d'extension d'au moins 5 %, en particulier d'au moins 15 % de la dimension correspondante du composant (3, 23, 43, 63).

4. Procédé selon la revendication 2 ou 3, **caractérisé en ce que** les dimensions du logement (10, 26, 42, 65) sont choisies de sorte qu'elles excèdent les dimensions du composant (3, 23, 43, 63) dans toutes les directions d'extension du composant (3, 23, 43, 63).

5. Procédé selon l'une des revendications 1 à 4, **caractérisé en ce que** le composant (3, 23, 43, 63) électronique à intégrer est formé par un capteur, par exemple pour la détermination de la température, de l'humidité, de la pression, de l'acoustique, de la clarté, de l'accélération, de la position spatiale, de la composition de milieux gazeux ou liquides, d'un élément à haute fréquence ou similaire.

6. Procédé selon l'une des revendications 1 à 5, **caractérisé en ce qu'**au moins un orifice de passage (11, 30, 47) débouchant dans le logement (10, 26, 42) pour la réception du composant (3, 23, 43) à intégrer est réalisé dans un élément de carte de circuits imprimés (1, 21, 41).

7. Procédé selon l'une des revendications 1 à 6, **caractérisé en ce que** la protection est formée au moins en partie par des strates conductrices (12, 27, 50) sensiblement sur toute la surface des éléments de carte de circuits imprimés (4, 24, 41).

8. Procédé selon la revendication 7, **caractérisé en ce que** des zones conductrices (12, 27, 50, 68) utilisées pour la protection des éléments de carte de circuits imprimés (4, 24, 41, 66) sont en outre assemblées par des contacts conducteurs (13, 28, 51, 69, 73) entre les zones conductrices des éléments de carte de circuits imprimés.

9. Procédé selon l'une des revendications 1 à 8, **caractérisé en ce que** l'électronique d'évaluation (31, 45) pour le composant (23, 43) est intégrée dans l'élément de carte de circuits imprimés (21, 41), sur lequel le composant (23, 43) électronique est appuyé ou avec lequel le composant électronique est mis en contact.

10. Procédé selon l'une des revendications 1 à 9, **caractérisé en ce que** l'assemblage (5, 25, 49, 67) des éléments de carte de circuits imprimés (1, 4, 21, 24, 41, 48, 61, 66) est effectué d'une manière connue en soi par brasage, liaison eutectique, liaison par thermocompression, brasage par diffusion, en utilisant une colle conductrice et/ou de feuilles adhésives conductrices ou conductibles ou similaires.
